(19) Europäisches Patentamt / European Patent Office / Office européen des brevets

(11) **EP 1 975 703 A2**

(12) **EUROPEAN PATENT APPLICATION**

(43) Date of publication:
**01.10.2008 Bulletin 2008/40**

(51) Int Cl.:
***G03F 7/00*** *(2006.01)*

(21) Application number: **08153534.6**

(22) Date of filing: **28.03.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **30.03.2007 JP 2007094876**
**27.12.2007 JP 2007337316**

(71) Applicant: **Fujifilm Corporation**
**Tokyo 106-8620 (JP)**

(72) Inventors:
• **Kenichi, Moriwaki,**
**c/o Fujifilm Corporation**
**Odawara-shi, Kanagawa (JP)**
• **Masakazu Nishikawa,**
**c/o Fujifilm Corporation**
**Odawara-shi, Kanagawa (JP)**

(74) Representative: **Thun, Clemens**
**Mitscherlich & Partner**
**Sonnenstrasse 33**
**80331 München (DE)**

(54) **Mold structure, imprinting method using the same, magnetic recording medium and production method thereof**

(57) The present invention provides a mold structure including: a concavo-convex pattern formed on its surface, wherein the mold structure is used for transferring the concavo-convex pattern onto an imprint resist layer formed on a surface of a substrate having a thickness of 0.3mm to 2.0mm by placing the concavo-convex pattern against the imprint resist layer, and wherein a thickness Dm (mm) of the mold structure, a thickness Ds (mm) of the substrate and an area S1 (mm$^2$) of the mold structure satisfy the Relationship $1.0 \leq (Dm/Ds) \times S_1^{1/2} \leq 100$.

## FIG. 1

Printed by Jouve, 75001 PARIS (FR)

**EP 1 975 703 A2**

**Description**

BACKGROUND OF THE INVENTION

Field of the Invention

The present invention relates to a mold structure provided with a concavo-convex pattern used for transferring information onto a magnetic recording medium, an imprinting method using the same, a magnetic recording medium and a method for producing the magnetic recording medium.

Description of the Related Art

In recent years, hard disk drives that are superior in high-speed reading and writing process and low in costs have begun being incorporated in portable devices such as cellular phones, compact acoustic devices and video cameras as major storage devices, and a technique for increasing recording density has been required to meet the demand for further sizing down and increasing capacity.

In order to increase the recording density of hard disk drives, a method of improving the performance of magnetic recording media and a method of narrowing the magnetic head width have been conventionally used; however, as spaces between data tracks are made narrow, effects of magnetism between adjacent tracks (crosstalk) and effects of heat fluctuation become noticeable, so that there is a limitation on improvement in recording density by means of the narrowing of magnetic heads or the like.

Accordingly, magnetic recording media in a form referred to as discrete track media have been proposed as a solution to noise caused by crosstalk (refer to Japanese Patent Application Laid-Open (JP-A) Nos. 56-119934 and 02-201730).

In discrete track media, magnetic interference between adjacent tracks is decreased by means of discrete structures in which nonmagnetic guard band regions are provided between adjacent tracks so as to magnetically separate tracks from one another.

Also, magnetic recording media in a form referred to as bit patterned media, in which bits for recording signals are provided in predetermined patterns of shape, have been proposed as a solution to demagnetization caused by heat fluctuation (refer to JP-A No. 03-22211).

As a method for producing the discrete track media and the bit patterned media, there is an imprinting method in which a desired pattern is transferred onto a resist layer formed on a surface of a magnetic recording medium by using a resist pattern forming mold (otherwise referred to as "stamper"), as disclosed in JP-A No. 2004-221465.

Incidentally, when a mold is used for transferring a pattern onto a magnetic recording medium, it is necessary to carry out nanoimprint lithography (NIL) finely and for a large area, and thus uniformity and stability of NIL are important. In addition, it is necessary to mainly create two types of patterns, i.e. a servo signal used for positioning a magnetic head and a data signal used in reading/recording actual data. A data portion is formed of a simple pattern, for example a concentric pattern in the case of a discrete track medium (DTM) or a dotted pattern in the case of a bit patterned medium (BPM). A servo portion is mainly formed of four patterns exemplified by a preamble, a servo timing mark, an address (sector and cylinder) and a burst. In the address (sector and cylinder) and burst pattern portions, patterns are present in a mixed manner, thereby creating complex pattern arrangements.

Since a complex pattern is densely formed over an entire surface of a disk as described above, accurate transfer of a concavo-convex pattern of a mold structure to an entire surface of an imprint resist layer is required during NIL.

In this imprinting method, since a large number of transfer processes are required in view of cost reduction, it is necessary for the mold structure to withstand at least several hundreds to several tens of thousands of times of transfer.

Accordingly, in order to improve durability in transfer, a technique in which a rigid body such as a silicon substrate is used in a mold structure has been disclosed (refer to US Patent No. 5772905 and Appl. Phys. Lett., vol. 67, 3314, 1995 by S.Y. Chou, et al.). According to the patent literature, very high pattern accuracy can be obtained, and it is possible to realize transfer of minute patterns including those of submicron size or of the order of several tens of nanometers.

Here, a thick and rigid mold structure formed of a silicon substrate or the like cannot fully correspond with the variety of shapes of substrates whose surfaces are covered with imprint resist layers to be imprinted with patterns; hence, it is difficult to transfer the patterns uniformly onto the entire surfaces of the imprint resist layers, using the mold structure.

Also, when the areas of portions to be imprinted with the patterns are enlarged, there is a problem with the flatness of the mold structures, and thus it is difficult to transfer the patterns uniformly, using the mold structures.

Moreover, when the mold structure is thick, it becomes heavier and also poor in handleability; hence, there is a problem with its applicability to production processes.

Meanwhile, when the substrate is made thin, those problems can be solved; however, the mold structure itself may possibly deform or be damaged, in other words the durability of the mold structure may possibly decrease (refer to JP-A No. 2004-288845).

Therefore, as things stand at present, a mold structure which is highly durable and excellent in the transfer quality of a pattern to a substrate and which allows a high-quality pattern to be transferred and formed on discrete track media and patterned media, and related techniques have not yet been realized, and provision thereof is hoped for.

BRIEF SUMMARY OF THE INVENTION

The present invention is aimed at solving the problems in related art and achieving the following object. Specifically, an object of the present invention is to provide a mold structure which is highly durable and excellent in the transfer quality of a pattern to a substrate and which allows a high-quality pattern to be transferred and formed on discrete track media and patterned media; an imprinting method using the same; a magnetic recording medium; and a method for producing the magnetic recording medium.

As a result of carrying out earnest examinations, the present inventors have found that the mold structure can be brought into good contact with the substrate in an imprinting process by reducing the thickness of the mold structure and increasing the thickness of the substrate, and found that by increasing the area of the mold structure, it is possible to prevent decrease in the strength of a concavo-convex pattern, which decreases as the mold structure becomes thin, and thus to solve the problems.

The present invention is based upon the aforementioned knowledge of the present inventors, and the following are means for solving the aforementioned problems.

<1> A mold structure including: a concavo-convex pattern formed on its surface, wherein the mold structure is used for transferring the concavo-convex pattern onto an imprint resist layer formed on a surface of a substrate having a thickness of 0.3mm to 2.0mm by placing the concavo-convex pattern against the imprint resist layer, and wherein a thickness Dm (mm) of the mold structure, a thickness Ds (mm) of the substrate and an area S1 ($mm^2$) of the mold structure satisfy Relationship (1) below.

$$\text{Relationship (1): } 1.0 \leq (Dm/Ds) \times S_1^{1/2} \leq 100$$

As to the mold structure according to <1>, it is possible to identify an appropriate value for the thickness of the mold structure by determining the relationships among the thickness of the mold structure, the thickness of the substrate and the area of the mold structure, and thus it is possible to improve handleability. Therefore, it is possible to provide a mold structure which is highly durable and excellent in the transfer quality of a pattern to a substrate and which allows a high-quality pattern to be transferred and formed on discrete track media and patterned media.

<2> The mold structure according to <1>, wherein the thickness Dm of the mold structure, the thickness Ds of the substrate, the area $S_1$ of the mold structure and a surface area $S_2$ ($mm^2$) of the concavo-convex pattern satisfy Relationship (2) below.

$$\text{Relationship (2): } 0.01 \leq (Dm/Ds) \times (S_2/S_1)^{1/2} \leq 1$$

<3> The mold structure according to one of <1> and <2>, wherein the mold structure has a thickness of 0.01mm or greater, and less than 0.5mm.

<4> The mold structure according to any one of <1> to <3>, wherein the mold structure is formed of a material selected from quartz, nickel and resin.

<5> An imprinting method including: transferring a concavo-convex pattern formed on a surface of a mold structure onto an imprint resist layer on a surface of a substrate by placing the concavo-convex pattern against the imprint resist layer, wherein a thickness Dm (mm) of the mold structure, a thickness Ds (mm) of the substrate and an area $S_1$ ($mm^2$) of the mold structure satisfy Relationship (1) below.

$$\text{Relationship (1): } 1.0 \leq (Dm/Ds) \times S_1^{1/2} \leq 100$$

<6> A method for producing a magnetic recording medium, including: transferring a concavo-convex pattern formed on a mold structure onto an imprint resist layer formed on a substrate of the magnetic recording medium by pressing the mold structure against the imprint resist layer; forming a magnetic pattern portion, which corresponds with the concavo-convex pattern, on a magnetic layer on a surface of the substrate of the magnetic recording medium by etching the magnetic layer, using the imprint resist layer onto which the concavo-convex pattern has been transferred as a mask; and forming a nonmagnetic pattern portion by filling concave portions in the magnetic layer with a nonmagnetic material, wherein the mold structure is the mold structure according to any one of <1> to <4>.

<7> A magnetic recording medium produced by the method for producing a magnetic recording medium according to <6>.

<8> A method for producing a magnetic recording medium, including: producing a magnetic recording medium with the use of the imprinting method according to <5>.

<9> The method for producing a magnetic recording medium according to <8>, wherein the magnetic recording medium is one of a discrete magnetic recording medium and a patterned magnetic recording medium.

<10> A magnetic recording medium produced by the method for producing a magnetic recording medium according to one of <8> and <9>.

<11> The magnetic recording medium according to <10>, which is one of a discrete magnetic recording medium and a patterned magnetic recording medium.

According to the present invention, it is possible to solve problems in related art and provide a mold structure which is highly durable and excellent in the transfer quality of a pattern to a substrate and which allows a high-quality pattern to be transferred and formed on discrete track media and patterned media; an imprinting method using the same; a magnetic recording medium; and a method for producing the magnetic recording medium.

BRIEF DESCRIPTION OF THE SEVERAL VIEWS OF THE DRAWINGS

FIG. 1 is a partial perspective view showing the constitution of one embodiment of a mold structure according to the present invention.

FIG. 2A is a cross-sectional view showing a method for producing a mold structure according to a first embodiment.

FIG. 2B is another cross-sectional view showing the method for producing a mold structure according to the first embodiment.

FIG. 3 is a cross-sectional view showing a method for producing a magnetic recording medium by using a mold structure according to the present invention.

FIG. 4A is a cross-sectional view showing a method for producing a mold structure according to a second embodiment.

FIG. 4B is another cross-sectional view showing the method for producing a mold structure according to the second embodiment.

FIG. 5A is a cross-sectional view showing a method for producing a mold structure according to a third embodiment.

FIG. 5B is another cross-sectional view showing the method for producing a mold structure according to the third embodiment.

DETAILED DESCRIPTION OF THE INVENTION

The following in the present invention explains mold structures for DTM, with reference to the drawings.

<Constitution of Mold Structure>

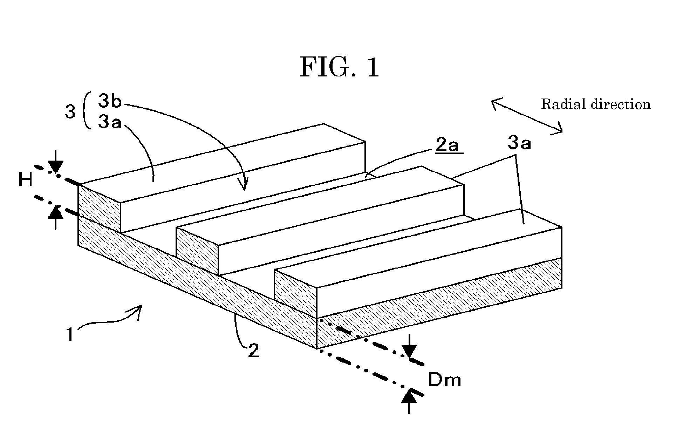

FIG. 1 is a partial perspective view showing the constitution of one embodiment of a mold structure according to the present invention.

As shown in FIG. 1, a mold structure 1 of the present embodiment has a plurality of convex portions 3a formed in the shape of concentric circles at predetermined intervals on one surface 2a (hereinafter otherwise referred to as "reference surface 2a") of a disk-shaped substrate 2. The convex portions are provided correspondingly to a servo portion and a data portion of a magnetic recording medium. The data portion is formed of a pattern of convexities substantially in the shape of concentric circles and records data. The servo portion is formed of a plurality of different patterns of convexities with different areas. The servo portion corresponds to a tracking servo control signal and is mainly composed, for example, of a preamble pattern, a servo timing mark, an address pattern, a burst pattern or the like. The preamble pattern generates a reference clock signal for reading control signals from an address pattern region, etc. The servo timing mark serves as a trigger signal for reading the address and burst patterns. The address pattern includes sector (angle) information and track (radius) information and presents the absolute position (address) of a disk. The burst pattern has the function of finely adjusting the magnetic head's position and thus enabling highly accurate positioning, when the magnetic head is in a on-track state.

The material for the substrate 2 of the mold structure is not particularly limited and can be suitably selected according to the purpose, with any one of quartz, metal and resin being preferable.

Examples of the metal include Ni, Cu, Al, Mo, Co, Cr, Ta, Pd, Pt, Au and alloys thereof. Among these, Ni and alloys of Ni are particularly preferable.

Examples of the resin include polyethylene terephthalate (PET), polyethylene naphthalate (PEN), polycarbonate (PC), polymethyl methacrylate (PMMA), cellulose triacetate (TAC) and low glass transition temperature fluorine resins.

Note that in the present embodiment, the convex portions 3a and concave portions 3b formed between the convex portions 3a are collectively referred to as "concavo-convex portions 3".

The cross-sectional shape of each of the convex portions 3a with respect to the radial direction of the concentric circles (the direction in which the convex portions 3a are disposed one after another) is a rectangle, for example.

It should be noted that the cross-sectional shape of each of the convex portions 3a is not limited to rectangle, and any shape can be selected according to the purpose by controlling the after-mentioned etching step.

Hereinafter, in explanations of the present embodiment, the term "cross-section(al shape)" denotes a cross-section(al shape) with respect to the radial direction of the concentric circles (the direction in which the convex portions 3a are disposed one after another) unless otherwise stated.

As to the mold structure 1 of the present invention, when the substrate 2 has a thickness of Dm (mm), the surface of the substrate 2 has a projection area of $S_1$ ($mm^2$) as measured from a normal direction, and a substrate, whose surface is covered with an imprint resist layer to be imprinted with a concavo-convex pattern by the mold structure 1, has a thickness of Ds (mm), it is desirable that the thickness Dm of the mold structure 1 satisfy Relationship (1) below. Note that Ds satisfies the relationship $0.3 \leq Ds \leq 2.0$. In the case where the thickness Ds of the substrate is less than 0.3mm, the rigidity of the substrate itself becomes low, and the flying stability of the magnetic head comes to be unstable because of surface shaking caused when the substrate is rotated at high speed. When the thickness Ds of the substrate is greater than 2.0mm, the substrate becomes heavier, so that not only can it be suitably applied to fewer products, but also there is an increase in material costs.

It is further desirable that the surface area $S_1$ be 1,000 ($mm^2$) or greater.

$$\text{Relationship (1): } 1.0 \leq (Dm/Ds) \times S_1^{1/2} \leq 100$$

Also as to the mold structure 1 of the present invention, when apical portions of the convex portions 3a that are a component of the concavo-convex pattern have an area of $S_2$ ($mm^2$), it is further desirable that the thickness Dm of the mold structure 1 satisfy Relationship (2) below.

Here, the area $S_2$ denotes an area calculated by approximating the apical portions of all the convex portions 3a to a surface parallel to the surface of the substrate 2 on the side where the convex portions 3a are formed (see the reference surface 2a in FIG. 1). The area $S_2$ is measured by a cross-sectional SEM image or a cross-sectional TEM image.

$$\text{Relationship (2): } 0.01 \leq (Dm/Ds) \times (S_2/S_1)^{1/2} \leq 1$$

Also, it is desirable that the thickness of the substrate 2 be 0.01mm or greater, and less than 0.5mm.

(Method for Producing Mold Structure)

The following explains a method for producing a mold structure according to the present invention, with reference to the drawings.

<First Embodiment>

<<Production of Master Plate>>

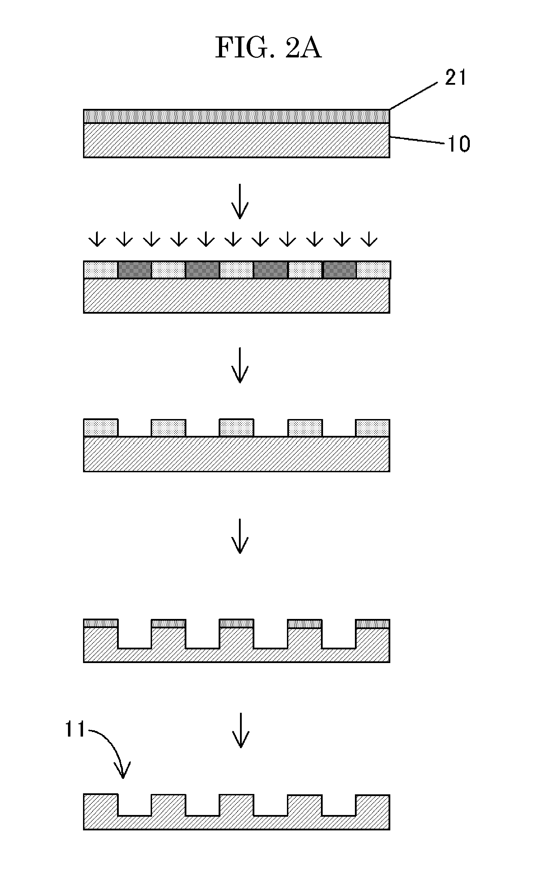

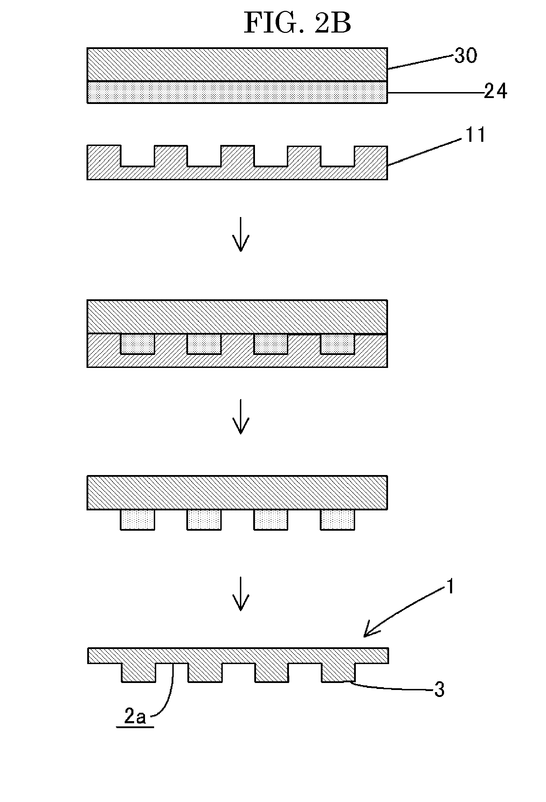

FIGS. 2A and 2B are cross-sectional views showing a method for producing a mold structure according to a first embodiment. First of all, as shown in FIG. 2A, a photoresist solution of PMMA, etc. is applied onto a Si substrate 10 by spin coating or the like to form a photoresist layer 21.

After that, while the Si substrate 10 is being rotated, a laser beam (or an electron beam) modulated correspondingly to a data recording track and a servo signal is applied onto the Si substrate 10, and the entire photoresist surface is exposed with predetermined patterns, for example a data track pattern formed of a pattern of convexities substantially in the shape of concentric circles, a servo pattern formed of a plurality of different patterns of convexities with different areas, and a buffer pattern formed of a pattern of convexities which are radially arranged and continuous in the radial direction between the data track pattern and the servo pattern.

Subsequently, the photoresist layer 21 undergoes a developing process, exposed portions are removed, then selective etching is carried out by RIE (reactive ion etching) or the like as the pattern of the photoresist layer 21 after the removal serves as a mask, and a concavo-convex pattern is thus formed on the substrate 10. Next, the residual resist layer 21 is removed to yield a master plate 11 having a concavo-convex shape.

<<Production of Mold Structure>>

Next, as shown in FIG. 2B, the master plate 11 is pressed against a quartz substrate 30 that is a substrate to be processed, whose one surface is covered with an imprint resist layer 24 made by applying an imprint resist solution containing a photocurable resin or the like, and the patterns of the convex portions formed on the master plate 11 are thus transferred onto the imprint resist layer 24.

<<Imprint Resist Layer>>

The imprint resist layer is, for example, an imprint resist composition (hereinafter otherwise referred to as "imprint resist solution") containing at least one of thermoplastic resin, thermosetting resin and photocurable resin, and it is applied onto a substrate, a magnetic recording medium or the like.

The thickness of the imprint resist layer can, for example, be optically measured using an ellipsometer, etc. or measured by means of contact measurement using a stylus profilometer, an atomic force microscope (AFM), etc.

For the imprint resist composition, a material having thermoplasticity, a material having photocurability, a sol/gel or the like can be used. Suitable examples thereof include resins that have those features and also high dry etching resistance, such as novolac resins, epoxy resins and alicyclic resins; and resins having excellent peelability, such as fluorine resins.

Here, the material for the substrate to be processed in the present invention is not particularly limited and can be suitably selected according to the purpose, as long as it transmits light and has the strength necessary for it to function as a mold structure. Examples thereof include quartz ($SiO_2$) and organic resins (PET, PEN, polycarbonate, low glass transition temperature fluorine resins and PMMA).

The specific meaning of the expression "transmits light" is that the imprint resist is sufficiently cured when light is applied in such a manner as to enter one surface of the substrate to be processed and exit the other surface thereof covered with the imprint resist layer, and that the light transmittance from the one surface to the other surface is 50% or greater.

The specific meaning of the expression "has the strength necessary for it to function as a mold structure" is such strength as enables the material to withstand the pressurization when the master plate is pressed against the imprint resist layer on the substrate of the magnetic recording medium at 4kgf/cm$^2$ in average surface pressure.

<<Curing Step>>

Thereafter, the transferred pattern is cured by irradiating the imprint resist layer 24 with an ultraviolet ray or the like.

<<Pattern Forming Step>>

Subsequently, selective etching is carried out by RIE or the like, with the transferred pattern serving as a mask, to yield the mold structure 1 having a concavo-convex shape.

Note that the selective etching is carried out such that concave portions of the mold structure 1 having the concavo-convex shape correspond with the convex portions 3a in FIG. 1 in cross-sectional shape.

<<Release Layer Forming Step>>

A release agent layer is formed on the concavo-convex surface of the mold structure produced. It is desirable that the release agent layer be formed on the surface of the mold structure so as to be able to peel off at the interface between the mold structure and the imprint resist layer after imprinting. The material for the release agent can be arbitrarily selected, provided that it easily adheres and bonds to the mold structure and hardly adsorbs onto the imprint resist layer surface. In particular, fluorine resin is preferable in that it hardly adsorbs onto the resist layer surface.

It is desirable that the release agent layer be made as thin as possible because when it is thick, there is a reduction in pattern accuracy. Specifically, the thickness thereof is desirably 10nm or less, more desirably 5nm or less.

As a means of forming the release agent layer, coating or vapor deposition can be employed. Additionally, after the release agent layer has been formed, it is possible to provide, for example, a step of enhancing the adsorbability of the release agent to the mold structure by baking or the like.

<Second Embodiment>

<<Production of Master Plate>>

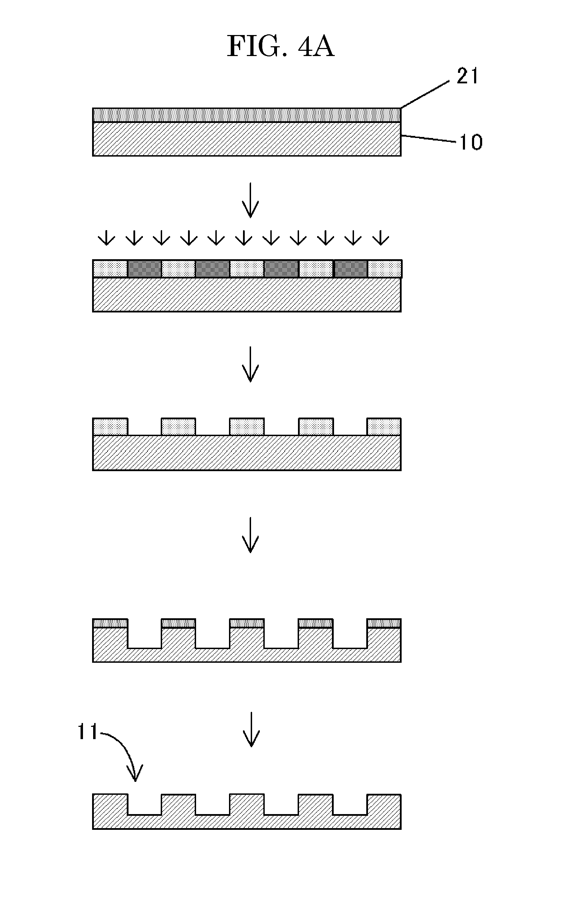

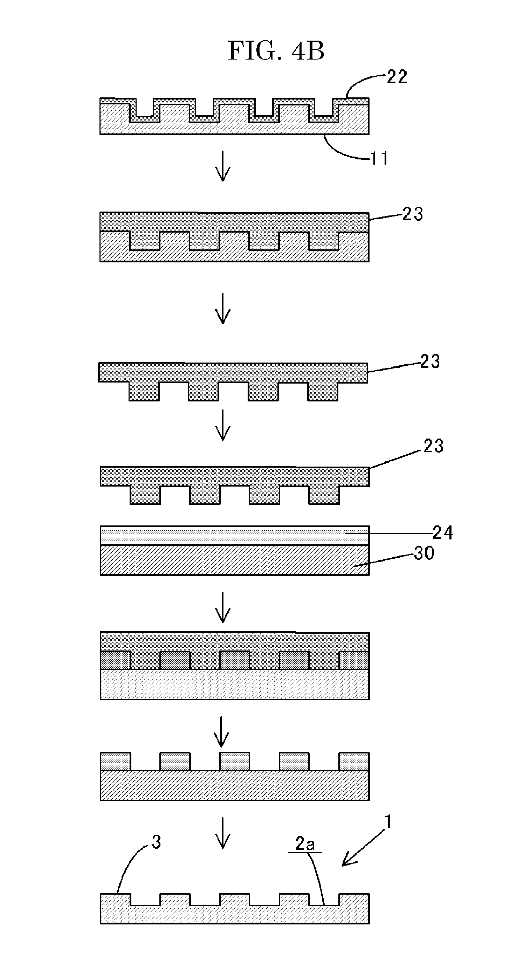

FIGS. 4A and 4B are cross-sectional views showing a method for producing a mold structure according to a second embodiment. A master plate 11 having a concavo-convex pattern was produced as in the first embodiment.

<<Production of Mold Structure>>

A Ni mold structure was produced by forming a conductive film on the surface of the master plate by sputtering, and immersing the master plate provided with the conductive film in a Ni electroforming bath to electroform the master plate.

A conductive film 22 can be formed on the concavo-convex pattern of the master plate 11 by processing a conductive material in accordance with a vacuum deposition method such as vacuum vapor deposition, sputtering or ion plating, a plating method, or the like. The conductive material can be suitably selected according to a subsequent step (electroforming), but it is preferably a Ni-based, Fe-based or Co-based metal/alloy material or the like. It is desirable that the thickness of the Ni mold structure obtained through the electroforming process be in the range of 20μm to 800μm, more desirably in the range of 40μm to 400μm.

<<Release Layer Forming Step>>

It is desirable that a release agent layer be formed on the surface of the Ni mold structure as in the first embodiment.

<Third Embodiment>

<<Production of Master Plate>>

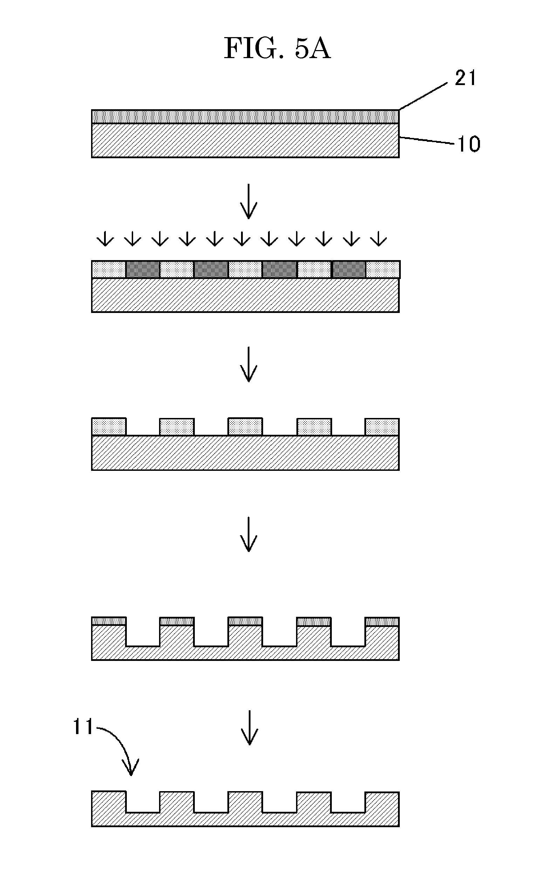

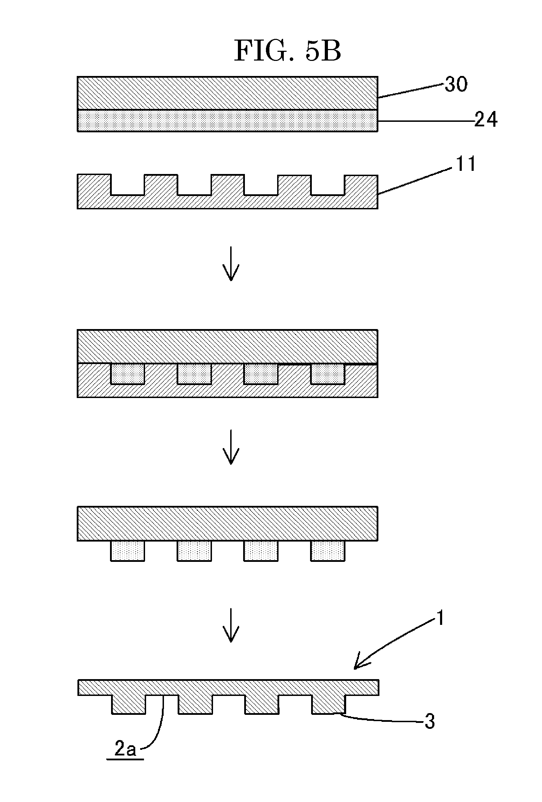

FIGS. 5A and 5B are cross-sectional views showing a method for producing a mold structure according to a third embodiment. A master plate 11 having a concavo-convex pattern was produced as in the first embodiment.

<<Production of Mold Structure>>

The master plate was pressed against a thermoplastic resin sheet. After that, by heating the sheet to a temperature equal to or higher than the softening temperature of the resin, the viscosity of the resin decreased, and the pattern of convex portions formed on the master plate was transferred onto the resin sheet. Subsequently, the transferred pattern was cured by cooling, and the resin sheet was peeled away from the master plate to yield a resin mold structure having a concavo-convex shape.

Here, the resin material is not particularly limited and can be suitably selected according to the purpose, as long as it has thermoplasticity, transmits light and has the strength necessary for it to function as a mold structure. Examples thereof include PET, PEN, polycarbonate, low glass transition temperature fluorine resins and PMMA.

The specific meaning of the expression "transmits light" is that an imprint resist is sufficiently cured when light is applied in such a manner as to enter one surface of a substrate to be processed and exit the other surface thereof covered with an imprint resist layer, and that the light transmittance from the one surface to the other surface is 50% or greater.

The specific meaning of the expression "has the strength necessary for it to function as a mold structure" is such strength as enables the resin material to withstand the pressurization when the master plate is pressed against the imprint resist layer on a substrate of a magnetic recording medium at $4kgf/cm^2$ in average surface pressure.

<<Release Layer Forming Step>>

It is desirable that a release agent layer be formed on the surface of the resin mold structure as in the first embodiment.

The mold structure of the present invention can be suitably used in an imprinting method including a transfer step in which the convex portions of the mold structure are placed facing the resist layer, and the concavo-convex pattern is transferred onto the resist layer. It can be particularly suitably used in the present invention's method for producing a magnetic recording medium, explained below.

<Method for Producing Magnetic Recording Medium>

The present invention's method for producing a magnetic recording medium includes the steps of: transferring a concavo-convex pattern formed on the mold structure of the present invention onto an imprint resist layer on a substrate of a magnetic recording medium, by pressing the mold structure against the imprint resist layer; curing the concavo-convex pattern transferred onto the imprint resist layer and separating the mold structure from the imprint resist layer; forming a magnetic pattern portion, which corresponds with the concavo-convex pattern, on a magnetic layer over the surface of the substrate of the magnetic recording medium by etching the magnetic layer, using the imprint resist layer onto which the concavo-convex pattern has been transferred as a mask; and forming a nonmagnetic pattern portion by filling concave portions in the magnetic layer with a nonmagnetic material. Also, the method may include other step(s) according to necessity.

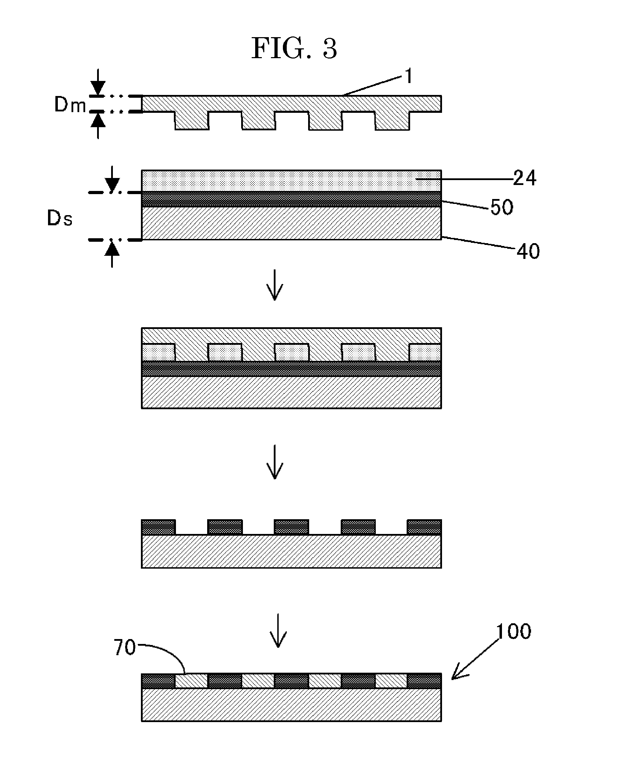

The following explains one example of a method for producing magnetic recording media such as discrete track media or patterned media, with reference to FIG. 3.

(Transfer Step)

A mold structure incorporating a concavo-convex pattern on its surface is pressed against a resist-layer-coated magnetic recording medium intermediate member in which a resist layer 24 made by applying an imprint resist solution of polymethyl methacrylate (PMMA) or the like onto the magnetic recording medium intermediate member's magnetic layer 50 formed of Fe (or Fe alloy), Co (or Co alloy), etc. is provided on a substrate made of aluminum, glass, silicon, quartz or the like. By doing so, the concavo-convex pattern formed on the mold structure is transferred onto the resist layer 24.

(Curing Step)

- Curing by Light Irradiation -

In the case where an imprint resist composition constituting the imprint resist layer contains a photocurable resin, the imprint resist layer is irradiated with an ultraviolet ray, an electron beam or the like via a transparent mold structure 1 for imprinting, and the imprint resist layer is thus cured.

The photocurable resin used herein is a radical polymerization type resin or a cationic polymerization type resin and can be suitably selected from these according to the pattern accuracy and the curing rate that are required.

- Curing by Heating -

In the case where the imprint resist composition constituting the imprint resist layer contains a thermoplastic resin, when the mold structure 1 for imprinting is pressed against the imprint resist layer, the temperature of the system is kept in the vicinity of the glass transition temperature (Tg) of the resist solution, and after the pattern has been transferred, the imprint resist layer is cured as its temperature becomes lower than the glass transition temperature of the resist solution. Further, if necessary, an ultraviolet ray or the like may be additionally applied to cure the pattern.

In the case where the imprint resist composition contains a thermosetting resin, while the imprint resist composition is kept at room temperature or heated and so shows fluidity, the mold structure 1 for imprinting is pressed against the imprint resist layer to transfer the concavo-convex pattern onto the imprint resist layer, then the imprint resist layer is heated as high as the curing temperature of the resin. By doing so, the imprint resist layer is cured.

(Magnetic Pattern Portion Forming Step)

Next, dry etching is carried out, using the resist layer onto which the pattern of the concavo-convex portions has been transferred as a mask, and a concavo-convex shape corresponding with the concavo-convex pattern is formed on the magnetic layer.

The dry etching is not particularly limited and can be suitably selected according to the purpose, as long as it makes it possible to provide the concavo-convex shape on the magnetic layer. Examples thereof include ion milling, reactive ion etching (RIE) and sputter etching. Among these, ion milling and reactive ion etching (RIE) are particularly preferable.

The ion milling, also referred to as "ion beam etching", is a process of injecting an inert gas such as Ar into an ion source to produce ions, and accelerating these ions through a grid to collide with a sample substrate for etching the sample substrate. Examples of the ion source include Kaufman ion sources, high-frequency ion sources, electron impact ion sources, duoplasmatron ion sources, Freeman ion sources, ECR (electron cyclotron resonance) ion sources and closed-drift ion sources.

As a process gas in the ion beam etching, Ar or the like can be used. As an etchant in the RIE, any one of $CO+NH_3$, chlorine gas, CF gas, CH gas, mixtures of these gases and oxygen gas, nitrogen gas or hydrogen gas, and the like can be used.

(Nonmagnetic Pattern Portion Forming Step)

Next, concave portions formed in the magnetic layer are filled with a nonmagnetic material to flatten the surface of the magnetic layer, then a protective film and the like are formed according to necessity. By doing so, a magnetic recording medium 100 can be produced.

Examples of the nonmagnetic material include $SiO_2$, carbon, alumina, polymers such as polymethyl methacrylate (PMMA) and polystyrene (PS), and lubricant oils.

Suitable examples of the material for the protective film include diamond-like carbon (DLC) and sputter carbon. Additionally, a lubricant layer may be provided on the protective film.

The magnetic recording medium produced by the present invention's method for producing a magnetic recording medium is preferably either a discrete magnetic recording medium or a patterned magnetic recording medium.

EXAMPLES

(Example 1)

<Production of Mold Structure>

FIGS. 2A and 2B are cross-sectional views showing a method for producing the mold structure in the first embodiment. As shown in FIG. 2A, an electron beam resist was applied onto a Si substrate 10 by spin coating to form a layer of 100nm in thickness. The electron beam resist was exposed with a desired pattern, using a rotary electron beam exposing apparatus, and then subjected to a developing process to yield a resist-coated Si substrate having a concavo-convex pattern.

Subsequently, with the resist pattern serving as a mask, the following reactive ion etching (RIE) was carried out to provide a concavo-convex pattern on the Si substrate.

plasma source: ICP (inductively coupled plasma) source

gas: CF gas plus a small amount of hydrogen gas

pressure: 0.5Pa

electric power supplied: ICP-300W, bias-50W

Thereafter, residual resist was washed out with a solvent capable of dissolving it, and then the Si substrate was dried to yield a master plate.

Broadly, the pattern used in Example 1 was functionally divided into a data portion and a servo portion. The data portion was formed of a pattern in which convexities were 120nm each in width and concavities were 30nm each in width (TP=150nm). The servo portion had on its innermost circumference a servo basic bit length of 90nm and a total sector number of 240 and was formed of a pattern of a preamble (45bit); a servo mark portion (10bit); a sector code (8bit) and a cylinder code (32bit); and a burst portion.

The servo mark portion employed the number "0000101011", and the sector code and the cylinder code employed binary conversion and gray conversion respectively. The burst portion employed a typical phase burst signal (16bit).

Next, a photocurable acrylic imprint resist solution (PAK-01 produced by Toyo Gosei Co., Ltd.) was applied onto a quartz substrate by spin coating to form a layer of 100nm in thickness.

Subsequently, the master plate was used as a mold structure and subjected to UV nanoimprinting. In the UV nanoimprinting, the pattern was transferred onto the imprint resist layer under a pressure of 1MPa for 5sec, then a UV light of $25mJ/cm^2$ was applied for 10sec to cure the pattern.

Selective etching was carried out by the following RIE correspondingly with the concavo-convex resist pattern after the nanoimprinting so as to provide a concavo-convex shape on the quartz substrate.
plasma source: ICP (inductively coupled plasma) source
gas: 1:1 mixture of CF gas and Ar gas, with a small amount of hydrogen gas pressure: 0.5Pa
electric power supplied: ICP-300W, bias-60W
Thereafter, residual resist was washed out with a solvent capable of dissolving it, and then the quartz substrate was dried to yield a quartz mold. Note that the selective etching was carried out such that concave portions of the mold structure 1 having the concavo-convex shape corresponded with the convex portions 3a in FIG. 1 in cross-sectional shape.

<Formation of Release Layer>

A release agent layer was formed on the concavo-convex surface of the produced mold structure by a wet process. As the material for the release agent layer, F13-OTCS (tridecafluoro-1,1,2,2-tetrahydro-octyltrichlorosilane) (produced by Gelest, Inc.) was used, and a release layer solution (0.1% by mass) was prepared by dissolving it in a solvent ASAHIKLIN AK225 (produced by Asahi Glass Co., Ltd.). With the use of this release layer solution, a release layer of 5.25nm in thickness was formed on the quartz mold by a dip method in which the lifting rate was 1mm/sec.
The mold structure with the release layer was left to stand at 90°C and at an RH of 80% for 5hr, and then the release layer material was chemically adsorbed onto the mold structure surface (chemical combining process). The mold structure of Example 1 was thus produced.

<Production of Magnetic Recording Medium Intermediate Member>

A soft magnetic layer, a first nonmagnetic orientation layer, a second nonmagnetic orientation layer, a magnetic recording layer and a protective layer were deposited in this order over a 2.5-inch glass substrate in the following manner. The soft magnetic layer, the first nonmagnetic orientation layer, the second nonmagnetic orientation layer, the magnetic recording layer and the protective layer were sputtered by sputtering. Additionally, a lubricant layer on the protective layer was formed by a dip method.
Firstly, as the material for the soft magnetic layer, CoZrNb was sputtered to form a layer of 100nm in thickness. Specifically, the glass substrate was set facing the CoZrNb target, then Ar gas was injected such that its pressure became 0.6Pa, and the soft magnetic layer was sputtered at 1,500W (DC).
Secondly, as the first nonmagnetic orientation layer, Pt was sputtered to form a layer of 5nm in thickness. Specifically, the soft magnetic layer formed over the substrate was set facing the Pt target, then Ar gas was injected such that its pressure became 0.5Pa, and the first nonmagnetic orientation layer was sputtered at 1,000W (DC).
Thirdly, as the second nonmagnetic orientation layer, Ru was sputtered to form a layer of 10nm in thickness. Specifically, the first nonmagnetic orientation layer formed over the substrate was set facing the Ru target, then Ar gas was injected such that its pressure became 0.5Pa, and the second nonmagnetic orientation layer was sputtered at 1,000W (DC).
Fourthly, as the magnetic recording layer, $CoPtCr-SiO_2$ was sputtered to form a layer of 15nm in thickness. Specifically, the second nonmagnetic orientation layer formed over the substrate was set facing the $CoPtCr-SiO_2$ target, then Ar gas was injected such that its pressure became 1.5Pa, and the magnetic recording layer was sputtered at 1,000W (DC).
Lastly, after the formation of the magnetic recording layer, the protective layer formed over the substrate was set facing a C target, then Ar gas was injected such that its pressure became 0.5Pa, and the protective layer of 4nm in thickness was sputtered at 1,000W (DC). A magnetic recording medium intermediate member was thus produced. The coercive force of the magnetic recording medium intermediate member yielded was 334kA/m (4.2kOe).

<Nanoimprinting and Production of Discrete-type Perpendicular Magnetic Recording Medium>

A photocurable acrylic imprint resist solution (PAK-01 produced by Toyo Gosei Co., Ltd.) was applied onto the produced magnetic recording medium intermediate member by spin coating to form a layer of 100nm in thickness.
The mold structure was set facing the obtained magnetic recording medium intermediate member with the resist layer. The concavo-convex pattern was transferred onto the resist layer, with the magnetic recording medium intermediate member pressed under a pressure of 1MPa for 5sec, then a UV light of 25mJ/cm[2] was applied for 10sec to cure the pattern. Subsequently, the mold structure and the magnetic recording medium intermediate member were separated from each other, and a concavo-convex pattern was thus formed on the resist layer over the magnetic recording medium intermediate member.
Thereafter, as the imprint resist layer 24 onto which the pattern of the concavo-convex portions 3 has been transferred served as a mask, selective etching was carried out by Ar ion sputter etching (ICP plasma source, Ar gas, 0.2Pa, ICP/bias=750W/300W); a concavo-convex shape corresponding with the pattern of the concavo-convex portions 3 on the mold structure 1 for imprinting was formed on the magnetic layer 50; concave portions were filled with a nonmagnetic material 70 ($SiO_2$ formed by CVD) to flatten the surface of the magnetic layer 50 (by CMP); then a protective layer was formed (a DLC protective layer was formed by CVD) to yield the magnetic recording medium 100. Thus, a discrete-type perpendicular magnetic recording medium of Example 1 was produced.

<<Evaluation of Transfer Quality>>

When a concavo-convex pattern (line and space: 50nm and 50nm, height: 50nm) was transferred onto an imprint resist layer on a surface of a substrate using the mold structure of Example 1, a residual film of the imprint resist layer was evaluated in eight locations which were away from the center by 30nm and apart from one another by 45°. The residual film was observed for thickness using cross-sectional TEM images, and the amount of unevenness (maximum value - minimum value in terms of thickness) of the residual film was evaluated in accordance with the following evaluation standards. The evaluation result is shown in Table 1-1.

(Evaluation Standards)

A: the amount of unevenness was 40nm or less.
B: the amount of unevenness was over 40nm.

<<Evaluation of Durability>>

A process of transferring the concavo-convex pattern onto an imprint resist layer on a surface of a substrate with the use of the mold structure of Example 1 was carried out 100 times, and then the mold structure was checked for fractures and microcracks in accordance with the following evaluation standards by means of an ultrasonic image method. The evaluation result is shown in Table 1-1.

(Evaluation Standards)

A: there were no fractures or microcracks
B: there were fractures and microcracks

<<Evaluation of Servo Characteristic>>

Regarding the magnetic recording medium produced above, a position error signal (PES) of a reproduction signal was measured using a magnetic head tester for hard disks (BITFINDER Model-YS 3300 produced by IMES Co., Ltd.) having a GMR head of $0.1\mu m$ in reproduction track width and $0.06\mu m$ in reproduction gap, and the position error signal (PES) was evaluated in accordance with the following evaluation standards. The evaluation result is shown in Table 1-1.

(Evaluation Standards)

A: a magnetic recording medium capable of servo following, in which the PES was equivalent to less than $\pm10\%$ of the track width.
B: a magnetic recording medium capable of servo following, in which the PES was equivalent to $\pm10\%$ or greater and $\pm20\%$ or less of the track width.
C: a magnetic recording medium incapable of servo following.

(Examples 2 to 13 and 16 to 28)

<Production of Mold Structure>

Mold structures of Examples 2 to 13 and 16 to 28 were produced similarly to the one of Example 1, except that the values of the thickness (Dm) and surface area ($S_1$) of the mold structure and the surface area ($S_2$) of the concavo-convex pattern in Example 1 were changed to the values shown in Tables 1-1 and 1-2.

<Production of Magnetic Recording Medium>

Magnetic recording media of Examples 2 to 13 and 16 to 28 were produced similarly to the one of Example 1, except that the mold structures and the magnetic recording medium intermediate members shown in Tables 1-1 and 1-2 were used instead of the mold structure and the magnetic recording medium intermediate member of Example 1.

<<Evaluation of Transfer Quality>>

The mold structures and the magnetic recording medium intermediate members of Examples 2 to 13 and 16 to 28 produced were evaluated for transfer quality as in Example 1. The evaluation results are shown in Tables 1-1 and 1-2.

<<Evaluation of Durability>>

The mold structures of Examples 2 to 13 and 16 to 28 produced were evaluated for durability as in Example 1. The evaluation results are shown in Tables 1-1 and 1-2.

<<Evaluation of Servo Characteristic>>

The magnetic recording media of Examples 2 to 13 and 16 to 28 produced were evaluated for servo characteristics as in Example 1. The evaluation results are shown in Tables 1-1 and 1-2.

(Examples 29 and 30)

<Production of Mold Structure>

There was a master plate 11 having a concavo-convex shape, produced similarly to the one of Example 1, and a conductive film 22 was formed on the surface of the master plate 11 correspondingly with the concavo-convex pattern on the surface thereof by sputtering. Subsequently, the master plate provided with the conductive film 22 was immersed in a Ni electroforming bath of the following composition and electroformed while being rotated at a rotational speed of 50rpm to 150rpm, and a Ni plate having a positive concavo-convex pattern of $300\mu m$ in thickness was thus produced. Thereafter, the Ni plate was separated from the master plate, a residual resist film was removed, and the Ni plate was washed.
Each one of mold structures of Examples 29 and 30 was thus obtained.

- Components and Temperature of Ni Electroforming Bath -
nickel sulfamate               600g/L
boric acid                     40g/L
surfactant (sodium lauryl sulfate)   0.15g/L
pH=4.0
temperature=55°C

The thickness (Dm) and surface area ($S_1$) of the mold structures obtained and the surface area ($S_2$) of the concavo-convex patterns are shown in Table 1-2.
Note that when a Ni plate 23 was produced with the conductive film 22 having a predetermined thickness, the production was carried out such that concave portions of the Ni plate 23 corresponded with the convex portions 3a in FIGS. 2A and 2B in cross-sectional shape.

<Production of Magnetic Recording Medium>

An imprint resist solution formed of PMMA resin was applied onto a magnetic recording medium intermediate member produced similarly to the one of Example 1, by spin coating to form a layer of 100nm in thickness.

The mold structure formed of Ni was set facing the obtained magnetic recording medium intermediate member with the resist layer. The concavo-convex pattern was transferred onto the resist layer under a pressure of 3MPa at a temperature of 150°C for 30sec, then the temperature was lowered to 60°C to cure the pattern. Thereafter, the mold structure and the magnetic recording medium intermediate member were separated from each other, and a concavo-convex pattern was thus formed on the resist layer over the magnetic recording medium intermediate member.

Subsequently, with the concavo-convex pattern serving as a mask, etching was carried out to provide a concavo-convex shape on a magnetic recording layer. Each one of perpendicular magnetic recording media of Examples 29 and 30 was thus produced.

<<Evaluation of Transfer Quality>>

The mold structures and the magnetic recording medium intermediate members of Examples 29 and 30 produced were evaluated for transfer quality as in Example 1. The evaluation results are shown in Table 1-2.

<<Evaluation of Durability>>

The mold structures of Examples 29 and 30 produced were evaluated for durability as in Example 1. The evaluation results are shown in Table 1-2.

<<Evaluation of Servo Characteristic>>

The magnetic recording media of Examples 29 and 30 produced were evaluated for recording and reproducing characteristics as in Example 1. The evaluation results are shown in Table 1-2.

(Examples 14 and 15)

<<Production of Mold Structure>>

A thermoplastic resin formed of PMMA was set facing a master plate 11 having a concavo-convex shape produced similarly to the one of Example 1. The concavo-convex pattern was transferred onto the thermoplastic resin under a pressure of 3MPa at a temperature of 150°C for 30sec, then the temperature was lowered to 60°C to cure the pattern. Thereafter, by separating the thermoplastic resin from the master plate 11, a resin mold structure 1 having a concavo-convex shape, which represents each one of mold structures of Examples 14 and 15, was obtained.

The thickness (Dm) and surface area ($S_1$) of the mold structures obtained and the surface area ($S_2$) of the concavo-convex patterns are shown in Table 1-1.

<Production of Magnetic Recording Medium>

Magnetic recording media of Examples 14 and 15 were produced similarly to the one of Example 1, except that the mold structures shown in Table 1-1 were used instead of the mold structure of Example 1.

<<Evaluation of Transfer Quality>>

The mold structures and magnetic recording medium intermediate members of Examples 14 and 15 produced were evaluated for transfer quality as in Example 1. The evaluation results are shown in Table 1-1.

<<Evaluation of Durability>>

The mold structures of Examples 14 and 15 produced were evaluated for durability as in Example 1. The evaluation results are shown in Table 1-1. <<Evaluation of Servo Characteristic>>

The magnetic recording media of Examples 14 and 15 produced were evaluated for recording and reproducing characteristics as in Example 1. The evaluation results are shown in Table 1-1.

(Comparative Examples 1 and 2)

<Production of Mold Structure>

Mold structures of Comparative Examples 1 and 2 were produced similarly to the one of Example 1, except that the values of the thickness (Dm) and surface area ($S_1$) of the mold structure and the surface area ($S_2$) of the concavo-convex pattern in Example 1 were changed to the values shown in Table 1-2.

<Production of Magnetic Recording Medium>

Magnetic recording media of Comparative Examples 1 and 2 were produced similarly to the one of Example 1, except that the mold structures shown in Table 1-2 were used instead of the mold structure of Example 1.

<<Evaluation of Transfer Quality>>

The mold structures and magnetic recording medium intermediate members of Comparative Examples 1 and 2 produced were evaluated for transfer quality as in Example 1. The evaluation results are shown in Table 1-2.

<<Evaluation of Durability>>

The mold structures of Comparative Examples 1 and 2 produced were evaluated for durability as in Example 1. The evaluation results are shown in Table 1-2.

<<Evaluation of Recording and Reproducing Characteristic>>

The magnetic recording media of Comparative Examples 1 and 2 produced were evaluated for recording and reproducing characteristics as in Example 1. The evaluation results are shown in Table 1-2.

(Comparative Example 3)

<Production of Mold Structure>

A mold structure of Comparative Example 3 was produced similarly to the one of Example 14, except that the values of the thickness (Dm) and surface area ($S_1$) of the mold structure and the surface area ($S_2$) of the concavo-convex pattern in Example 14 were changed to the values shown in Table 1-2.

<Production of Magnetic Recording Medium>

A magnetic recording medium of Comparative Example 3 was produced similarly to the one of Example 14, except that the mold structure shown in Table 1-2 was used instead of the mold structure of Example 14.

<<Evaluation of Transfer Quality>>

The mold structure and a magnetic recording medium intermediate member of Comparative Example 3 produced were evaluated for transfer quality as in Example 14. The evaluation results are shown in Table 1-2.

<<Evaluation of Durability>>

The mold structure of Comparative Example 3 produced was evaluated for durability as in Example 14. The evaluation results are shown in Table 1-2.

<<Evaluation of Recording and Reproducing Characteristic>>

The magnetic recording medium of Comparative Example 3 produced was evaluated for recording and reproducing characteristics as in Example 14. The evaluation results are shown in Table 1-2.

Table 1-1

| | Dm (mm) | Ds (mm) | $S_1$ (mm$^2$) | $S_2$ (mm$^2$) | $S_2/S_1$ | $(S_2/S_1)^{0.5}$ | Relationship (1) | Relationship (2) | Transfer quality | Durability | Servo characteristic | Material |
|---|---|---|---|---|---|---|---|---|---|---|---|---|
| Example 1 | 0.3 | 0.635 | 2,851 | 570 | 0.2 | 0.45 | 25.23 | 0.211 | A | A | A | Quartz |
| Example 2 | 0.35 | 0.635 | 2,851 | 570 | 0.2 | 0.45 | 29.43 | 0.246 | A | A | A | Quartz |
| Example 3 | 0.4 | 0.635 | 2,851 | 570 | 0.2 | 0.45 | 33.63 | 0.282 | A | A | A | Quartz |
| Example 4 | 0.45 | 0.635 | 2,851 | 570 | 0.2 | 0.45 | 37.84 | 0.317 | A | A | A | Quartz |
| Example 5 | 0.5 | 0.635 | 2,851 | 570 | 0.2 | 0.45 | 42.04 | 0.352 | A | A | A | Quartz |
| Example 6 | 0.6 | 0.635 | 2,851 | 570 | 0.2 | 0.45 | 50.45 | 0.422 | A | A | A | Quartz |
| Example 7 | 0.8 | 0.635 | 2,851 | 570 | 0.2 | 0.45 | 67.27 | 0.563 | A | A | A | Quartz |
| Example 8 | 1 | 0.635 | 2,851 | 570 | 0.2 | 0.45 | 84.09 | 0.704 | A | A | A | Quartz |
| Example 9 | 1.2 | 0.69 | 2,851 | 570 | 0.2 | 0.45 | 92.86 | 0.778 | A | A | A | Quartz |
| Example 10 | 1.5 | 0.82 | 2,851 | 570 | 0.2 | 0.45 | 97.67 | 0.818 | A | A | A | Quartz |
| Example 11 | 1.9 | 1.05 | 2,851 | 570 | 0.2 | 0.45 | 96.62 | 0.809 | A | A | A | Quartz |
| Example 12 | 0.3 | 0.7 | 3,205 | 641 | 0.2 | 0.45 | 24.26 | 0.192 | A | A | A | Quartz |
| Example 13 | 0.3 | 0.8 | 2,851 | 1,426 | 0.5 | 0.71 | 20.02 | 0.265 | A | A | A | Quartz |
| Example 14 | 0.015 | 0.31 | 2,851 | 570 | 0.2 | 0.45 | 2.58 | 0.022 | A | B | A | Resin |
| Example 15 | 0.02 | 0.31 | 2,851 | 570 | 0.2 | 0.45 | 3.44 | 0.029 | A | B | A | Resin |
| Example 16 | 2 | 1.8 | 3,700 | 740 | 0.2 | 0.45 | 67.59 | 0.497 | A | A | A | Quartz |
| Example 17 | 2 | 1.2 | 2,851 | 570 | 0.2 | 0.45 | 88.99 | 0.745 | A | A | A | Quartz |
| Example 18 | 0.6 | 0.4 | 2,851 | 1,426 | 0.5 | 0.71 | 80.09 | 1.061 | A | A | B | Quartz |

(continued)

| | Dm (mm) | Ds (mm) | $S_1$ (mm$^2$) | $S_2$ (mm$^2$) | $S_2/S_1$ | $(S_2/S_1)^{0.5}$ | Relationship (1) | Relationship (2) | Transfer quality | Durability | Servo characteristic | Material |
|---|---|---|---|---|---|---|---|---|---|---|---|---|
| Example 19 | 0.6 | 0.45 | 3,205 | 1,603 | 0.5 | 0.71 | 75.48 | 0.943 | A | A | A | Quartz |
| Example 20 | 0.6 | 0.635 | 2,851 | 285 | 0.1 | 0.32 | 50.45 | 0.299 | A | A | A | Quartz |
| Example 21 | 0.6 | 0.635 | 3,205 | 1,603 | 0.5 | 0.71 | 53.49 | 0.668 | A | A | A | Quartz |
| Example 22 | 0.6 | 0.635 | 2,851 | 285 | 0.1 | 0.32 | 50.45 | 0.299 | A | A | A | Quartz |
| Example 23 | 0.6 | 0.635 | 3,205 | 1,603 | 0.5 | 0.71 | 53.49 | 0.668 | A | A | A | Quartz |
| Example 24 | 0.2 | 0.635 | 2,851 | 285 | 0.1 | 0.32 | 16.82 | 0.100 | A | B | B | Quartz |

Table 1-2

| | Dm (mm) | Ds (mm) | $S_1$ (mm$^2$) | $S_2$ (mm$^2$) | $S_2/S_1$ | $(S_2/S_1)$ 0.5 | Relationship (1) | Relationship (2) | transfer quality | durability | servo characteristic | material |
|---|---|---|---|---|---|---|---|---|---|---|---|---|
| Example 25 | 0.3 | 0.635 | 3,205 | 1,603 | 0.5 | 0.71 | 26.75 | 0.334 | A | A | A | Quartz |
| Example 26 | 0.4 | 0.635 | 3,205 | 160 | 0.0 | 0.22 | 35.66 | 0.141 | A | A | A | Quartz |
| Example 27 | 0.3 | 0.635 | 3,205 | 32 | 0.0 | 0.10 | 26.75 | 0.047 | A | B | B | Quartz |
| Example 28 | 0.3 | 0.635 | 3,700 | 1,850 | 0.5 | 0.71 | 28.74 | 0.334 | A | A | A | Quartz |
| Example 29 | 0.01 | 0.635 | 6,400 | 6,400 | 1.0 | 1.0 | 1.26 | 0.016 | A | A | B | Ni |
| Example 30 | 0.02 | 0.635 | 2,851 | 1,426 | 0.5 | 0.71 | 1.68 | 0.022 | A | A | B | Ni |
| Comparative Example 1 | 0.05 | 0.1 | 3,205 | 641 | 0.2 | 0.45 | 28.31 | 0.224 | A | B | C | Quartz |
| Comparative Example 2 | 0.1 | 2.5 | 2,851 | 570 | 0.2 | 0.45 | 2.14 | 0.018 | A | B | C | Quartz |
| Comparative Example 3 | 0.015 | 1.5 | 150 | 641 | 4.3 | 2.07 | 0.12 | 0.021 | A | B | C | Resin |

Since the mold structure of the present invention allows a minute pattern formed on the mold structure to enter a resist on a substrate efficiently and makes it possible to provide the pattern on the substrate with a high yield, it can be suitably used for producing discrete media and patterned media.

**Claims**

1. A mold structure comprising:

   a concavo-convex pattern formed on its surface,

   wherein the mold structure is used for transferring the concavo-convex pattern onto an imprint resist layer formed on a surface of a substrate having a thickness of 0.3mm to 2.0mm by placing the concavo-convex pattern against the imprint resist layer, and
   wherein a thickness Dm (mm) of the mold structure, a thickness Ds (mm) of the substrate and an area $S_1$ ($mm^2$) of the mold structure satisfy Relationship (1) below.

$$\text{Relationship (1): } 1.0 \leq (Dm/Ds) \times S_1^{1/2} \leq 100$$

2. The mold structure according to claim 1, wherein the thickness Dm of the mold structure, the thickness Ds of the substrate, the area $S_1$ of the mold structure and a surface area $S_2$ ($mm^2$) of the concavo-convex pattern satisfy Relationship (2) below.

$$\text{Relationship (2): } 0.01 \leq (Dm/Ds) \times (S_2/S_1)^{1/2} \leq 1$$

3. The mold structure according to any one of claims 1 and 2, wherein the mold structure has a thickness of 0.01mm or greater, and less than 0.5mm.

4. The mold structure according to any one of claims 1 to 3, wherein the mold structure is formed of a material selected from quartz, nickel and resin.

5. An imprinting method comprising:

   transferring a concavo-convex pattern formed on a surface of a mold structure onto an imprint resist layer on a surface of a substrate by placing the concavo-convex pattern against the imprint resist layer,

   wherein a thickness Dm (mm) of the mold structure, a thickness Ds (mm) of the substrate and an area $S_1$ ($mm^2$) of the mold structure satisfy Relationship (1) below.

$$\text{Relationship (1): } 1.0 \leq (Dm/Ds) \times S_1^{1/2} \leq 100$$

6. A method for producing a magnetic recording medium, comprising:

   transferring a concavo-convex pattern formed on a mold structure onto an imprint resist layer formed on a substrate of the magnetic recording medium by pressing the mold structure against the imprint resist layer,
   forming a magnetic pattern portion, which corresponds with the concavo-convex pattern, on a magnetic layer on a surface of the substrate of the magnetic recording medium by etching the magnetic layer, using the imprint resist layer onto which the concavo-convex pattern has been transferred as a mask, and
   forming a nonmagnetic pattern portion by filling concave portions in the magnetic layer with a nonmagnetic material,

wherein the mold structure is the mold structure according to any one of claims 1 to 4.

7. A magnetic recording medium produced by the method for producing a magnetic recording medium according to claim 6.

# FIG. 1

# FIG. 2A

# FIG. 2B

30

24

11

1

2a

3

# FIG. 3

# FIG. 4A

# FIG. 4B

# FIG. 5A

21

10

11

# FIG. 5B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 56119934 A
- JP 2201730 A
- JP 3022211 A

- JP 2004221465 A
- US 5772905 A
- JP 2004288845 A

**Non-patent literature cited in the description**

- **S.Y. CHOU.** *Appl. Phys. Lett.,* 1995, vol. 67, 3314